# EUROPEAN PATENT APPLICATION

(11) **EP 3 349 352 A1**
(43) Date of publication of application: **18.07.2018**
(21) Application number: 18150747.6
(22) Date of filing: 09.01.2018
(51) Int. Cl.: H02S 30/20

(54) **WINDOW BLIND**

(30) Priority: 11.01.2017 KR 20170004346
(71) Applicant: LG Electronics Inc., Seoul 07336 (KR)
(72) Inventor: CHEUN, Hyeunseok, 06772 Seoul, (KR); KIM, Jeongshik, 06772 Seoul (KR); SHIN, Junoh, 06772 Seoul (KR); YOON, Wonki, 06772 Seoul (KR); LEE, Jeongsoo, 06772 Seoul (KR)
(74) Representative: Katérle, Axel

(57) **Abstract**

A window blind of the present invention includes a slat having a convex curved surface; and a solar cell module having solar cells and being attached to the convex curved surface of the slat, wherein carrier generating portions of the solar cells are made of a thin film group III-V compound semiconductor that can be bent, so that the solar cells can be attached to the convex curved surface, the length of the curved surface of the solar cell module in the longitudinal direction is at least half the length of the curved surface of the slat in the longitudinal direction, and the solar cell module is disposed eccentrically to one side with respect to the transverse centerline of the slat.

## Description

### BACKGROUND OF THE INVENTION

### 1. Field of the Invention

The present invention relates to a window blind having solar cells that can produce electric power.

### 2. Description of the Conventional Art

The location of buildings to which solar cells can be applied is divided into a roof and wall. Mostly, the solar cells have been installed on the roof of the buildings. However, since the solar cells installed on the roof has a limited power generation area, it is difficult to meet the amount of power generation required in social housings or high-rise buildings. Therefore, it is necessary to additionally install the solar cells on the wall.

With respect to the types of installing the solar cells on the wall, an outer wall type, a window integral type, and a window blind type can be considered depending on the installation position of the solar cells. However, in the case of the outer wall type and the window integral type, there is a problem that the amount of power generation decreases according to the installation angles of the solar cells. Therefore, the window blind type which can adjust the installation angles of the solar cells is most effective in terms of power generation performance.

The requirements for the solar cells to be applied to the window blind include flexibility, lightweight characteristics, and high output. Slats of the window blind have convex curved surfaces for structural rigidity and solar radiation control. Further, the solar cells should be flexible enough to be installed on the slats. In addition, the solar cells should be lightweight since the heavy ones can not be installed on the slats. Finally, the solar cells must have high output characteristics to provide high output generation over the same area.

### SUMMARY OF THE INVENTION

It is one object of the present invention to provide a window blind having solar cells as an alternative for eliminating power load of a building, in particular, solar cells having flexibility, lightweight characteristics, and high output performance for installation on the window blind.

Another object of the present invention is to provide a solar cell module having an optimum size relative to the area of a slat, considering solar radiation by regions of the slat.

A further object of the present invention is to provide an electrical connection structure between solar cell modules installed on each slat.

In order to achieve the aforementioned objects of the present invention, a window blind according to one embodiment of the present invention includes a slat having a convex curved surface; and a solar cell module having solar cells and being attached to the convex curved surface of the slat. Carrier generating portions of the solar cells are made of a thin film group III-V compound semiconductor that can be bent, so that the solar cells can be attached to the convex curved surface. Then, the solar cell module is disposed at an optimum position with an optimum size in consideration of power generation efficiency. The length of the curved surface of the solar cell module in the longitudinal direction is at least half the length of the curved surface of the slat in the longitudinal direction, and the solar cell module is disposed eccentrically to one side with respect to the transverse centerline of the slat.

The length of the curved surface of the solar cell module in the longitudinal direction is 70% or less of the length of the curved surface of the slat in the longitudinal direction.

Preferably, the length of the curved surface of the solar cell module in the longitudinal direction is 63 to 70% of the length of the curved surface of the slat in the longitudinal direction.

The lower end of the solar cell module is brought into contact with the lower end of the slat or spaced apart from the lower end of the slat by a predetermined distance, and the upper end of the solar cell module is brought into contact with the transverse centerline of the slat or disposed on the other side with respect to the transverse centerline. The predetermined distance is 1/10 or less of the length of the curved surface of the slat in the longitudinal direction.

The convex curved surface includes: a first curved surface corresponding to a region disposed on one side with respect to the transverse centerline; and a second curved surface corresponding to a region disposed on the other side with respect to the centerline and having the shadow created by the slat just above when light is projected in an inclined direction, and the solar cell module is disposed so that the area covering the first curved surface is larger than the area covering the second curved surface.

The solar cell module is disposed so that only 2/7 or less of the total area covers the second curved surface and the remaining 5/7 or more covers the first curved surface.

Inflection points may be formed on the slat along the transverse centerline, and the solar cell module may be disposed to cover the inflection points.

The solar cell module consists of a set of sub-modules including the solar cells, holes are formed in the slat on one side and the other side of each sub-module, the solar cell module includes ribbons for connecting the sub-modules in series to each other, and the ribbons are connected to two sub-modules disposed adjacent to each other through the holes via the rear surface of the convex curved surface, respectively.

The window blind further includes insulating tapes disposed to cover the holes and the ribbons exposed through the rear surface.

The sub-module consists of a set of the solar cells, and the sub-module includes an interconnector for connecting the solar cells in series to each other, the interconnector including: a base; a conductive layer provided on one surface of the base to contact two adjacent solar cells, respectively, to electrically connect the two adjacent solar cells to each other; and an insulating layer provided at the center of the conductive layer to prevent shorts in the solar cells.

The ribbon connected to the outermost sub-module among the sub-modules is extended to the rear surface through the hole and connected to the multi-contact connector disposed on the rear surface, the window blind further includes a cable connected to the multi-contact connector, and the cable is connected to the multi-contact connector of the slat just above and the multi-contact connector of the slat just below through the wiring hole formed in the slat.

The window blind further includes a support for surrounding the cable to prevent folding or twisting of the cable.

The window blind further includes an encapsulation film for covering the slat and the solar cell module to protect the solar cell module, the encapsulation film including: a first portion for covering the convex surface of the slat and the solar cell module; and two second portions provided on both sides of the first portion, respectively, and attached to the rear surface of the convex surface.

The window blind further includes a rear encapsulation film for covering the two second portions and the rear surface.

The window blind can be installed outside the building to be directly exposed to the sunlight.

### BRIEF DESCRIPTION OF THE DRAWINGS

The accompanying drawings, which are included to provide a further understanding of the invention and are incorporated in and constitute a part of this specification, illustrate exemplary embodiments and together with the description serve to explain the principles of the invention.

In the drawings:
FIG. 1 is a conceptual view showing a window blind according to the present invention.
FIG. 2 is a circuit structural view showing the window blind of FIG. 1.
FIG. 3 is a conceptual view showing slats and solar cell modules.
FIG. 4 is an exploded view showing the slat, the solar cell modules, an encapsulation film, and a rear encapsulation film.
FIG. 5 is a conceptual view showing the solar cell modules installed on the slat.
FIG. 6a is a conceptual view showing one side of an interconnector attached to the rear surface of the slat.
FIG. 6b is a conceptual view showing the other side of the interconnector attached to the rear surface of the slat.
FIG. 7 is a conceptual view showing the regions of the slats which the sunlight reaches and the regions of the slats in which the shadow is created.
FIG. 8 is a graph showing the relationship between the area ratio of the solar cell modules and the amount of power generation.
FIG. 9a is a plan view showing one side of the slat.
FIG. 9b is a bottom view showing the other side of the slat.

### DETAILED DESCRIPTION OF THE PREFERRED EMBODIMENTS

Hereinafter, a window blind related to the present invention will be described in detail with reference to the accompanying drawings. In the present disclosure, similar or same reference numerals are given to similar or same components even in different embodiments, and the description thereof is replaced with the first description. As used herein, the singular forms include the plural forms, unless the context clearly dictates otherwise.

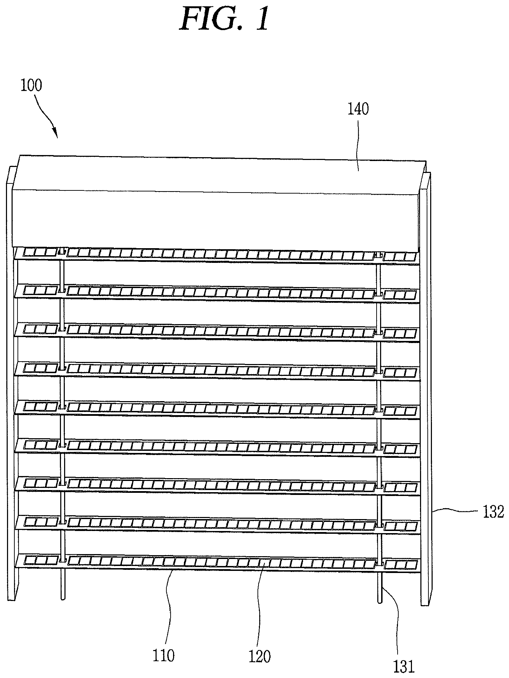

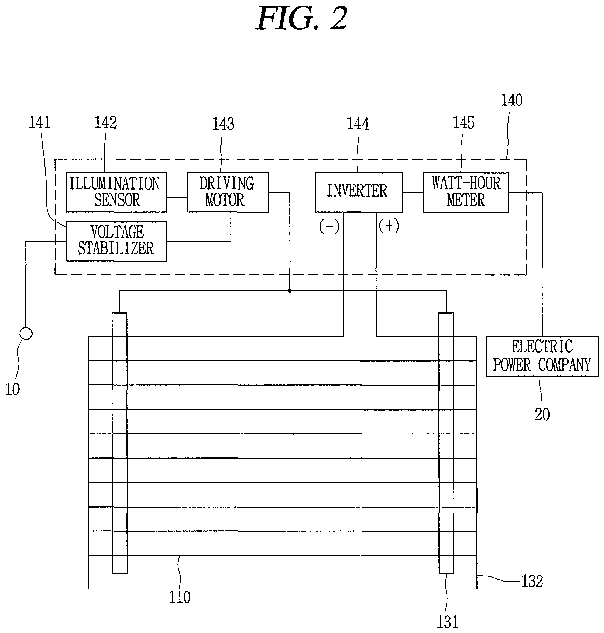

FIG. 1 is a conceptual view showing a window blind 100 of the present invention. FIG. 2 is a circuit structure view showing the window blind 100 of FIG. 1.

The window blind 100 refers to a device that is installed in a sunlit position, such as a window, to block the sunlight or make it impossible to look into the building from the outside. The window blind 100 includes slats 110, solar cell modules 120 and ropes 131 and may further include side frames 132 and a control module 140.

The slats 110 are provided to cover light. The plurality of slats 110 are arranged sequentially along the longitudinal direction. The slats 110 are connected to each other by the ropes 131. The slats 110 are moved by the ropes 131 and may be in close contact with each other or may be spaced apart from each other. The slats 110 are configured to be tiltable, spaced apart from each other. When the slats 110 are tilted toward the sun, they can block the sunlight entering the building.

The solar cell module 120 consists of a set of solar cells. The plurality of solar cells are connected in series to each other to form the solar cell module 120.

The solar cell module 120 is installed on one side of the slat 110. When the slats 110 are tilted toward the sun, spaced apart from each other, the solar cell modules 120 can generate electric power using the sunlight.

The ropes 131 connect the slats 110 in such a manner that they can be lifted, lowered, and tilted. The slats 110 connected to the ropes 131 are brought into close contact with each other while being lifted and are spaced apart from each other while being lowered. The operation of the ropes 131 is controlled by the control module 140.

The side frames 132 are installed on both sides of the slats 110. The side frames 132 may include guide rails (not shown) for setting the lifting and lowering paths of the slats 110. For example, the slats 110 may have protrusions (not shown) on both sides thereof, and these protrusions may be inserted into the guide rails of the side frames 132. When the guide rails extend in the lifting and lowering direction of the slats 110, the slats 110 move along the lifting and lowering paths set by the guide rails.

The control module 140 serves to perform the overall control of the window blind 100. For example, the control module 140 may be configured to control the movement of the slats 110 and the power generation of the solar cell modules 120. The control module 140 includes a voltage stabilizer 141, an illumination sensor 142, a driving motor 143, an inverter 144 and a watt-hour meter 145, for controlling the movement of the slats 110 and the power generation of the solar cell modules 120.

The voltage stabilizer 141 is electrically connected to a commercial power source 10 through a socket or the like and maintains a constant voltage regardless of an input voltage and load.

The illumination sensor 142 is configured to sense the brightness of light. The driving motor 143 can be operated according to the brightness of light sensed by the illumination sensor 142. For example, when there is excessive solar radiation, the driving motor 143 may be operated to lower and tilt the slats 110 to block the sunlight entering the building.

The driving motor 143 provides a driving force to the ropes 131 to move or tilt the slats 110 connected to the ropes 131.

The inverter 144 is configured to convert DC power produced by the solar cell modules 120 into AC power, and the AC power converted by the inverter 144 may be supplied or sold to an electric power company 20. The watt-hour meter 145 is configured to measure the amount of AC power supplied or sold to the electric power company 20.

The slats 110 and the solar cell modules 120 will be described below.

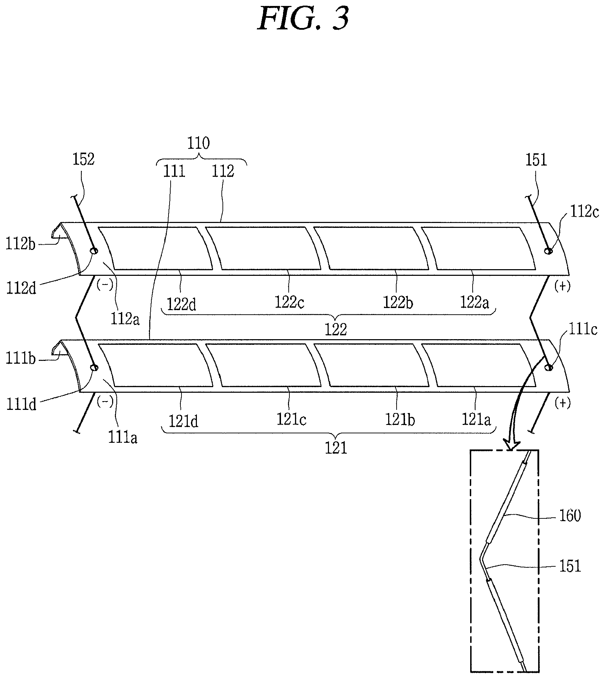

FIG. 3 is a conceptual view showing the slats 111 and 112 and the solar cell modules 121a, 121b, 121c, 121d, 122a, 122b, 122c and 122d.

The slats 111 and 112 have convex curved surfaces 111a and 112a. For example, as shown in FIG. 3, the front surfaces (or one side) of the slats 111 and 112 may be convex curved surfaces 111a and 112a, while the rear surfaces (or the other side) 111b and 112b of the slats 111 and 112 may be concave curved surfaces.

The slats 111 and 112 have the convex curved surfaces 111a and 112a for structural rigidity and solar radiation control.

When the slats 111 and 112 have plane surfaces, they may be easily folded due to an external force so that the left and right sides of the slats 111 and 112 overlap with each other. However, when the slats 111 and 112 have the convex curved surfaces 111a and 112a, they have a resistance against an external force, thereby achieving structural rigidity.

In addition, when the slats 111 and 112 have plane surfaces, light can be reflected between the two slats 111 and 112 to enter the building. However, when the slats 111 and 112 have the convex curved surfaces 111a and 112a, it is possible to address the above issues and control solar radiation.

The solar cell modules 121a, 121b, 121c, 121d, 122a, 122b, 122c and 122d are attached to the convex curved surfaces 111a and 112a of the slats 111 and 112, respectively. Since the solar cell modules 121a, 121b, 121c, 121d, 122a, 122b, 122c and 122d consist of a set of solar cells, each solar cell should be flexible so that the solar cell modules 121a, 121b, 121c, 121d, 122a, 122b, 122c and 122d can be attached to the convex curved surfaces 111a and 112a.

The conventional solar cells made of silicon generally have a size of 5 to 6 inches and have brittleness. Therefore, if the solar cells made of silicon are repeatedly bent, they do not maintain the mechanical strength and are deformed or broken as a result. Thus, the solar cells made of silicon do not have sufficient flexibility.

In addition, since the solar cells made of silicon have a limited efficiency, they are not suitable to be applied to the window blind 100 (see FIG. 1) having a size limitation. As long as the solar cells have a limited efficiency, the solar cell modules 121a, 121b, 121c, 121d, 122a, 122b, 122c and 122d applied to the window blind also have a limited amount of power generation.

In consideration of this point, the solar cells of the present invention include a thin film group III-V compound semiconductor to be attachable to the convex curved surfaces 111a and 112a. The fact that the solar cells contain a thin film group III-V compound semiconductor means that carrier (electron and hole) generating portions of the solar cells are made of the thin film group III-V compound semiconductor. Here, the carrier generating portions refer to portions where carriers are generated by the photoelectric effect. For example, the solar cell may have a flexible substrate, a lower electrode, a thin film III-V compound semiconductor, and an upper electrode, which are sequentially stacked, and the carrier is made of the group III-V compound semiconductor formed as a thin film.

The group III-V compound semiconductor may contain, e.g., a GaAs (gallium-arsenide) unit thin film, and may further contain GaInP (gallium-indium-phosphide), AlInP (aluminum-gallium-phosphide), and AlGaAs(aluminum-gallium-arsenide) unit thin films depending on the required voltage.

The thin film group III-V compound semiconductor that can be bent using an epitaxial lift off (ELO) technology is inherently smaller and thinner than the silicon semiconductor and is not easily broken as compared to silicon. This characteristic becomes a basis of achieving flexibility of the solar cell modules 121a, 121b, 121c, 121d, 122a, 122b, 122c and 122d.

The convex curved surfaces 111a and 112a of the slats 111 and 112 generally have a radius of curvature of about 180 R. 180 R means a radius of curvature of 180 mm. On the contrary, solar cells including a thin film group III-V compound semiconductor have a radius of curvature of about 50R (radius of curvature of 50 mm). Since a small radius of curvature indicates a large curvature, it means that the solar cells including the thin film group III-V compound semiconductor can be bent more than the convex curved surfaces 111a and 112a of the slats 111 and 112. Therefore, unlike the solar cells made of silicon, the solar cells including the thin film group III-V compound semiconductor can be bent and can also be attached to the convex curved surfaces 111a and 112a of the slats 111 and 112.

If the convex curved surfaces 111a and 112a of the slats 111 and 112 do not have a uniform curvature, inflection points exist on the convex curved surfaces 111a and 112a. However, even if the inflection points exist on the convex curved surfaces 111a and 112a, the solar cell including the thin film group III-V compound semiconductor have flexibility and thus can be attached on the inflection points as well.

The thin film group III-V compound semiconductor is thinner than the silicon semiconductor. The thin film group III-V compound semiconductor may have a thickness of 1 to 4 *µ*m. On the contrary, the silicon semiconductor generally have a thickness of about 200 *µ*m. In order to implement the solar cell modules 121a, 121b, 121c, 121d, 122a, 122b, 122c and 122d having flexibility, the thin film group III-V compound semiconductor preferably has a small thickness and can cause a sufficient photoelectric effect even with a thickness of 4 *µ*m or less, ensuring high efficiency.

In addition, the thin film group III-V compound semiconductor has higher efficiency and higher output than silicon. The solar cells including the thin film group III-V compound semiconductor shows an efficiency of 27 to 31%, while the solar cells including the silicon semiconductor shows an efficiency of 16 to 23%, under the same conditions. Since the solar cells that can be attached to the slats 111 and 112 have a limited number, the unit solar cell should have sufficiently high efficiency to meet the amount of power generation required in the window blind.

Furthermore, since the thin film group III-V compound semiconductor is lighter than silicon, it is suitable to be attached to the slats 111 and 112 of the window blind.

Meanwhile, the plurality of solar cell modules 121a, 121b, 121c, 121d, 122a, 122b, 122c and 122d are connected in series or parallel to each other, respectively. For example, the plurality of solar cell modules 121a, 121b, 121c, 121d, 122a, 122b, 122c and 122d attached to one slat 111 and 112 may be connected in series to each other. Also, when the plurality of solar cell modules 121a, 121b, 121c and 121d; 122a, 122b, 122c and 122d attached to one slat 111; 112 are referred to as one solar cell module group 121; 122, the respective solar cell module groups 121 and 122 may be connected in parallel to each other. The electrical connection between the solar cell module groups 121 and 122 is made by cables 151 and 152.

Wiring holes 111c, 111d, 112c and 112d may be formed at both ends of the slats 111 and 112, and the cables 151 and 152 may pass through the wiring holes 111c and 112c; 111d and 112d, respectively, to electrically connect the solar cell module groups 121 and 122 to each other. Based on any one slat 111, the cables 151 and 152 may be connected to the solar cell module group 122 of the slat 112 just above and the solar cell module group (not shown) of the slat just below, respectively. The cables 151 and 152 on both sides are connected to different polarities, so that one cable 151 may be connected to the (+) pole of the inverter 144 (see FIG. 2) and the other cable 152 may be connected to the (-) pole of the inverter 144.

The window blind may further include supports 160. There is a possibility that the cables 151 and 152 are folded or twisted while the slats 111 and 112 are lifted and lowered. If the cables 151 and 152 are repeatedly folded or twisted, shorts of the cables 151 and 152 may occur. The supports 160 surround the cables 151 and 152 to prevent folding or twisting of the cables 151 and 152. The supports 160 may be made of a metal, synthetic resin (plastic), synthetic fiber, or the like.

The configuration for protecting the solar cell modules 121a, 121b, 121c, 121d, 122a, 122b, 122c and 122d will be described below.

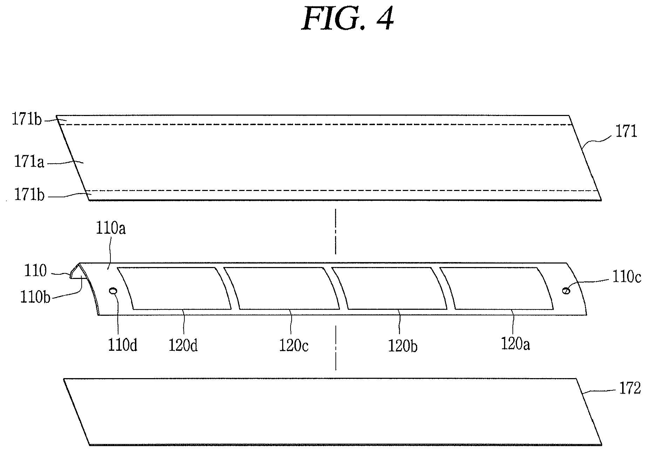

FIG. 4 is an exploded view showing the slat 110, the solar cell modules 120a, 120b, 120c and 120d, an encapsulation film 171, and a rear encapsulation film 172.

The slats 110 and the solar cell modules 120a, 120b, 120c and 120d have been described above in connection with FIG. 3.

The window blind 100 (see FIG. 1) of the present invention can be installed outside the building to be directly exposed to the sunlight. When the window blind is installed inside the building, the amount of light reaching the solar cell modules 120a, 120b, 120c and 120d is reduced due to reflection of light passing through the window. Accordingly, in order to maximize the amount of power generation, the window blind is preferably installed outside the building. However, in order for the window blind to be installed outside the building, the solar cell modules 120a, 120b, 120c and 120d as well as the configurations for the electrical connection between the solar cell modules 120a, 120b, 120c and 120d should be protected from the environment, such as water penetration or the like.

The window blind further includes the encapsulation film 171 and the rear encapsulation film 172 for protecting the solar cell modules 120a, 120b, 120c and 120d. The encapsulation film 171 and the rear encapsulation film 172 may be made of polyethylene phthalate (PET) and/or ethylene-vinyl acetate (EVA). A hard coating may be added to the top surface of the PET to prevent scratches due to external factors.

The encapsulation film 171 covers the slat 110 and the solar cell modules 120a, 120b, 120c and 120d to protect the solar cell modules 120a, 120b, 120c and 120d. The encapsulation film 171 can be attached not only to the convex curved surface 110a of the slat 110 but also to the rear surface 110b of the slat 110. When the encapsulation film 171 is divided into a first portion 171a and second portions 171b, the first portion 171a covers the convex curved surface 110a of the slat 110 and the solar cell modules 120a, 120b, and 120c and 120d, while the second portions 171b are attached to the rear surface 110b of the convex curved surface 110a. Here, the second portions 171b are provided on both sides of the first portion 171a as shown in FIG. 4.

When the encapsulation film 171 having a larger area than the slat 110 is attached to the convex curved surface 110a of the slat 110 through a primary lamination process, the solar cell modules 120a, 120b, 120c and 120d disposed on the convex curved surface 110a of the slat 110 are also attached to the slat 110. The lamination refers to a process of attaching the encapsulation film 171 to a plane surface or a curved surface by applying heat and pressure. During the primary lamination process, the two second portions 171b are protected by release films, and the primary lamination process allows the first portion 171a to be attached to the convex curved surface 110a of the slat 110 and the solar cell modules 120a, 120b , 120c and 120d.

After the primary lamination process is completed, the release films are removed, and the encapsulation film 171 is folded back at two spots based on the boundaries between the first portion 171a and the second portions 171b, brought into close contact with the rear surface 110b of the convex curved surface 110a, and attached to the rear surface 110b through a secondary lamination process.

The rear encapsulation film 172 is provided to cover the two second portions 171b and the rear surface 110b. The rear encapsulation film 172 may also be attached to the rear surface 110b of the slat 110 through the lamination process.

Hereinafter, the detailed structure of the solar cell modules 120a, 120b, 120c and 120d will be described below.

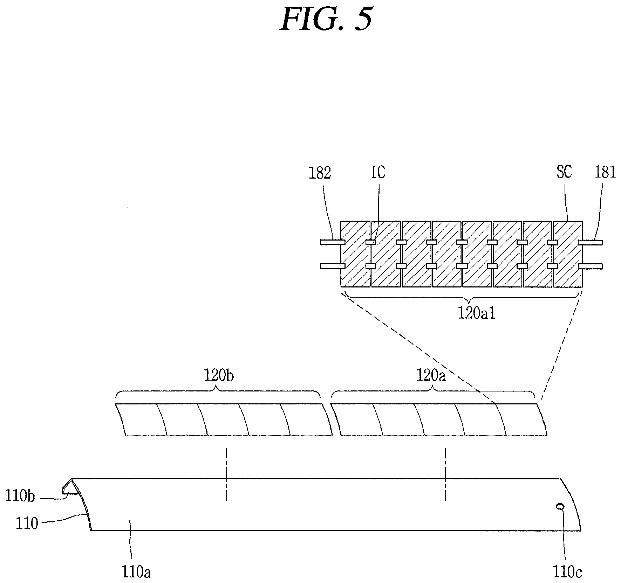

FIG. 5 is a conceptual view showing the solar cell modules 120a and 120b installed on the slat 110.

Each of the solar cell modules 120a and 120b consists of a set of sub-modules 120a1 having solar cells SC. One sub-module 120a1 consists of a set of solar cells SC, and one solar cell module 120a consists of a set of sub-modules 120a1. Then, the solar cell modules 120a and 120b are attached to the convex curved surfaces 111a and 112a of the slats 110, respectively.

The solar cell modules 120a and 120b may be connected in series or in parallel to each other, respectively.

Within one solar cell module 120a and 120b, the sub-modules 120a1 are connected in series to each other. The solar cell modules 120a and 120b include ribbons 181 and 182 for connecting the sub-modules 120a1 in series to each other. The ribbons 181 and 182 are provided on both sides of the sub-modules 120a1. The sub-modules 120a1 may be connected in series to each other as the ribbons 181 and 182 are connected to adjacent sub-modules 120a1.

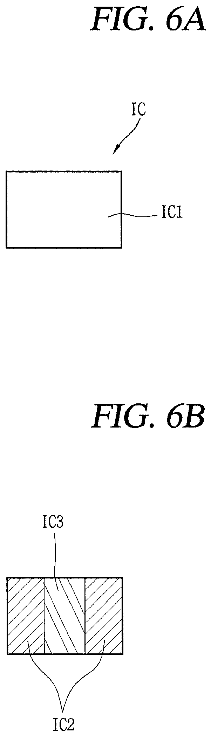

Within each sub-module 120a1, the solar cells SC are connected in series to each other, respectively. The sub-module 120a1 includes interconnectors IC for connecting the solar cells SC in series to each other. One or more interconnectors IC may be provided between the two solar cells SC. The structure of the interconnector IC will be described with reference to FIGS. 6a and 6b.

FIG. 6a is a conceptual view showing one side of the interconnector IC. FIG. 6b is a conceptual view showing the other side of the interconnector IC.

The interconnector IC includes a base IC1, a conductive layer IC2, and an insulating layer IC3.

The base IC1 may be made of copper (Cu) and may have a thickness of 10 to 200 *µ*m. If the base IC1 has a thickness smaller than 10 *µ*m, it can hardly maintain mechanical durability. If the base IC1 has a thickness greater than 200 *µ*m, the sub-module can hardly have flexibility.

The conductive layer IC2 is provided on one surface of the base IC1. The conductive layer IC2 may be formed by coating the base IC1 with a tin-lead alloy (SnPb). The conductive layer IC2 may have a thickness of 1 to 100 *µ*m. The conductive layer IC2 should have a thickness equal to or greater than 1 *µ*m to achieve reliability of the electrical connection and have a thickness equal to or smaller than 200 *µ*m to achieve flexibility of the sub-module.

The insulating layer IC3 is made of a nonconductive material to prevent shorts. The solar cell has a stacked structure of a flexible substrate, a lower electrode, a thin film group III-V compound semiconductor, and an upper electrode. When the lower electrode and the upper electrode are electrically connected to each other in one solar cell by the conductive layer IC2, the shorts occur.

However, if the insulating layer IC3 is disposed at the center of the conductive layer IC2, it can prevent the electrical connection between the lower electrode and the upper electrode and thus the occurrence of the shorts.

The interconnectors IC can be attached between the two solar cells by an electric conductive adhesive (ECA) or conductive paste. The interconnectors IC and the slats may be coated in dark color to match with the dark-colored solar cells in terms of design.

In order for the interconnectors IC and the slats to have a dark color, the coating should absorb a certain amount visible light. If the coating absorbs 80% or more of visible light incident on the interconnectors IC and the slats, they can match with the solar cells in terms of design.

The shadow created on the window blind and the optimal position and size of the solar cell module will be described below.

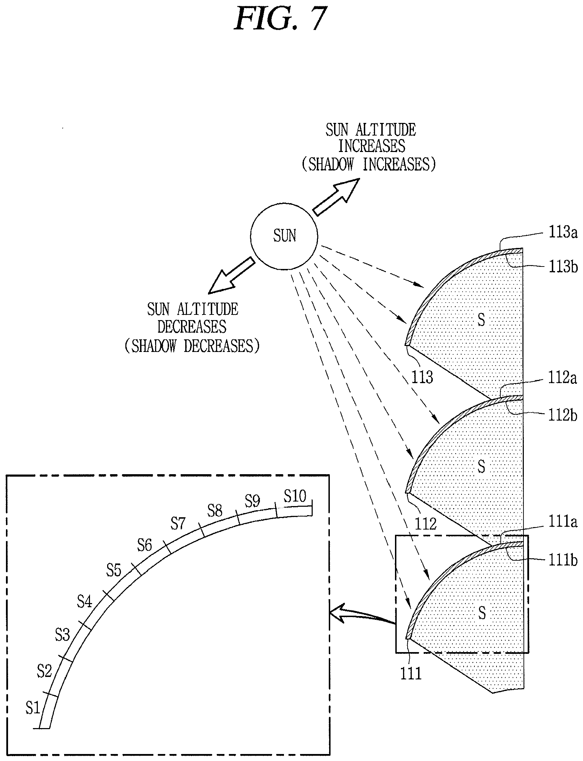

FIG. 7 is a conceptual view showing the regions of the slats 111, 112 and 113 which the sunlight reaches and the regions of the slats 111, 112 and 113 in which the shadow S is created.

When the ropes 131 (see FIG. 1) are moved by the operation of the driving motor 143 (FIG. 2) or by the manual operation of pulling them, the slats 111, 112 and 113 connected to the ropes are lowered and spaced apart from each other. Thereafter, the slats 111, 112, and 113 are rotated to be tilted to block the sunlight entering the building. In this state, the convex curved surfaces 111a, 112a and 113a of the slats 111, 112 and 113 are oriented toward the sun.

When the slats 111, 112 and 113 are disposed at regular intervals, if the sunlight is projected on the window blind, the shadow (S; shade) is created behind the rear surfaces 111b, 112b and 113b of the slats 111, 112 and 113 just above. When the window blind is installed outside the building, the shadow S is mostly created in the regions of the convex curved surfaces 111a, 112a and 113a of the slats 111, 112 and 113 that are adjacent to the building. The size of the shadow S depends on the altitude of the sun and the season or time, and thus varies with the season or time.

In order to maximize the amount of power generation of the solar cell modules, it is possible to consider covering the entire curved surfaces 111a, 112a and 113a with the solar cell modules. However, when the entire convex curved surfaces 111a, 112a and 113a are covered with the solar cell modules, the sunlight does not reach the regions in which the shadow S is created. Therefore, the solar cells disposed in the shadow S regions can not perform power generation, which unnecessarily increases the price of the window blind. Accordingly, it is necessary to analyze the shadow S of the slats 111, 112 and 113 by regions and months and then attach the solar cells to the optimal position with the optimal area, for the purposes of economical efficiency and power generation efficiency of the window blind. For example, the solar cells are disposed on the regions of the slats 111, 112 and 113 other than the shadow S regions.

In general, the solar cells are disposed occupying the same area on the respective slats 111, 112 and 113 for current matching. However, in some cases, the area of the solar cells may be larger in the slat 113 in which the shadow S is not created than the other slats 111 and 112. For example, the solar cells can be disposed only in the regions of the two lower slats 111 and 112 other than the regions in which the shadow S is created, and the solar cells can be disposed on the entire curved surface 113a of the uppermost slat 113.

Referring to FIG. 7, since the slats 111, 112 and 113 have the convex curved surfaces 111a, 112a and 113a, they are arc(circular arc)-shaped when viewed from the side. When this arc is equally divided into ten regions S1 to S10, the region farthest from the building is defined as S1 and the region nearest to the building is defined as S10, it is possible to analyze power generation efficiency of the solar cells by regions of the convex curved surfaces 111a, 112a and 113a.

Table 1 shows the results of analyzing power generation efficiency of the solar cells by regions of the convex curved surfaces 111a, 112a and 113a and months. The leftmost column numbers 1 to 12 in Table 1 mean the months of carrying out the power generation efficiency experiment of the solar cells. The uppermost row S1 to S10 in Table 1 mean the equally divided regions of the convex curved surfaces 111a, 112a and 113a of the slats 111, 112 and 113. S1 indicates the region farthest from the building, and S10 indicates the region nearest to the building. The respective numbers represent power generation efficiency of the solar cells between the minimum value of 0% and the maximum value of 100%.

**Table 1**

| | S1 | S2 | S3 | S4 | S5 | S6 | S7 | S8 | S9 | S10 |
|---|---|---|---|---|---|---|---|---|---|---|
| 1 | 60.0 | 0.0 | 0.0 | 0.0 | 0.0 | 0.0 | 0.0 | 0.0 | 0.0 | 0.0 |
| 2 | 80.0 | 40.0 | 0.0 | 0.0 | 0.0 | 0.0 | 0.0 | 0.0 | 0.0 | 0.0 |
| 3 | 100.0 | 91.7 | 83.3 | 0.0 | 0.0 | 0.0 | 0.0 | 0.0 | 0.0 | 0.0 |
| 4 | 100.0 | 100.0 | 100.0 | 100.0 | 100.0 | 40.0 | 20.0 | 0.0 | 0.0 | 0.0 |
| 5 | 100.0 | 100.0 | 100.0 | 100.0 | 100.0 | 100.0 | 75.0 | 25.0 | 0.0 | 0.0 |
| 6 | 100.0 | 100.0 | 100.0 | 100.0 | 100.0 | 100.0 | 100.0 | 50.0 | 25.0 | 0.0 |
| 7 | 100.0 | 100.0 | 100.0 | 100.0 | 100.0 | 100.0 | 100.0 | 50.0 | 25.0 | 00 |
| 8 | 100.0 | 100.0 | 100.0 | 100.0 | 100.0 | 80.0 | 40.0 | 20.0 | 20.0 | 0.0 |
| 9 | 100.0 | 100.0 | 100.0 | 100.0 | 16.7 | 8.3 | 8.3 | 0.0 | 0.0 | 0.0 |
| 10 | 81.8 | 63.6 | 0.0 | 0.0 | 0.0 | 0.0 | 0.0 | 0.0 | 0.0 | 0.0 |
| 11 | 60.0 | 0.0 | 0.0 | 0.0 | 0.0 | 0.0 | 0.0 | 0.0 | 0.0 | 0.0 |
| 12 | 40.0 | 0.0 | 0.0 | 0.0 | 0.0 | 0.0 | 0.0 | 0.0 | 0.0 | 0.0 |

Since the region S1 is the region most exposed to the sunlight each month, the solar cells disposed in the region S1 show the highest power generation efficiency. On the contrary, since the region S10 is the region in which the shadow S is always created every month, the solar cells disposed in the region S10 show the lowest power generation efficiency.

Though it depends on the month in which the experiment has been conducted, the solar cells disposed in the region S1 show the highest power generation efficiency, and then power generation efficiency of the solar cells tends to gradually decrease toward the region S10. From this data, it is possible to obtain the relationship between the area ratio occupied by the solar cell modules on the convex curved surfaces 111a, 112a and 113a of the slats 111, 112 and 113 and the amount of power generation.

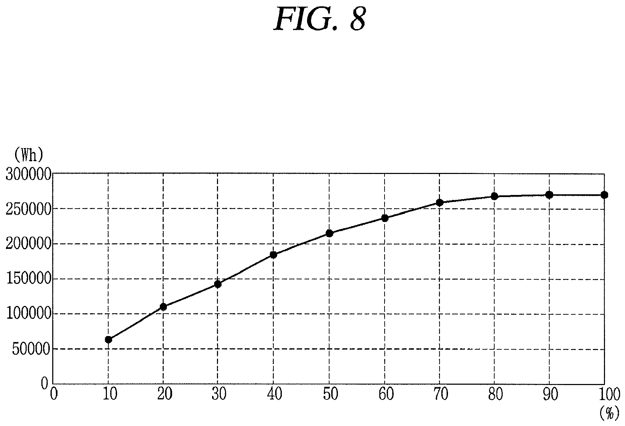

FIG. 8 is a graph showing the relationship between the area ratio of the solar cell modules and the amount of power generation.

The x axis of the graph indicates the area ratio (%) of the solar cell modules relative to the convex curved surfaces of the slats. The y axis of the graph indicates the annual amount of power generation (Wh).

The area ratio of the solar cell modules means how much the solar cell modules 120a and 120b cover the convex curved surfaces of the slats. As the area ratio of the solar cell modules increases, the area occupied by the solar cell modules on the convex curved surfaces of the slats increases.

The area ratio of the solar cell module can be derived from the length of the curved surface of the slat in the longitudinal direction and the length of the curved surface of the solar cell module in the longitudinal direction. The transverse direction of the slat is a direction that extends toward the two wiring holes formed on both sides of the slat, a direction that is longer than the longitudinal direction, or a direction that is parallel to the outer wall of the building. The longitudinal direction of the slat is a direction in which the convex curved surface is formed, a direction in which the arc of the slat is formed, a direction that is orthogonal to the transverse direction, or a direction that is shorter than the transverse direction.

For example, when the convex curved surface of the slat is uniformly divided into the regions S1 to S10 as shown in Table 1, if the lower end of the solar cell module is positioned at the boundary between the region S1 and the region S2 and the upper end of the solar cell module is positioned at the boundary between the region S6 and the region S7, the solar cell module covers the regions S2 to S6. Here, the length of the curved surface of the solar cell module in the longitudinal direction corresponds to 1/2 of the length of the curved surface of the slat in the longitudinal direction, since it extends from the boundary between the region S1 and the region S2 to the boundary between the region S6 and the region S7. And the area ratio of the solar cell module is 50% of the convex curved surface of the slat.

In order to maximize the amount of power generation using the solar cell modules 120a and 120b, the solar cell modules should be filled along the transverse direction of the slats. When the solar cell modules are filled along the transverse direction of the slats, the length of the curved surface of the solar cell modules in the longitudinal direction and the area ratio of the solar cell modules have substantially the same meaning.

Referring to FIG. 8, the annual amount of power generation tends to increase as the area ratio of the solar cell modules increases. In the section where the area ratio of the solar cell modules is 70% or less, the annual amount of power generation is almost proportional to the area ratio of the solar cell modules, reaching 90% or more of the total amount of power generation.

However, if the area ratio of the solar cell modules exceeds 70%, an increase in the annual amount of power generation is insignificant due to the shadow S created on the slats. From this, it can be seen that, in the sections with the area ratio exceeding 70%, an effect caused by an increase in the area ratio of the solar cell modules is saturated.

Therefore, it can be seen from the graph of FIG. 8 that the optimum area ratio of the solar cells relative to the convex curved surfaces of the slats is 70% or less. In order to achieve the amount of power generation of the solar cell modules, the area ratio of the solar cell modules should be 50% or more, and more preferably 63% or more with reference to the graph of FIG. 8. It is because, below 63%, the annual amount of power generation will continue to increase as the area ratio of the solar cells increases.

This means that the length of the curved surface of the solar cell module in the longitudinal direction should be not less than half, and not more than 70%, more preferably 63 to 70%, of the length of the curved surface of the slat in the longitudinal direction.

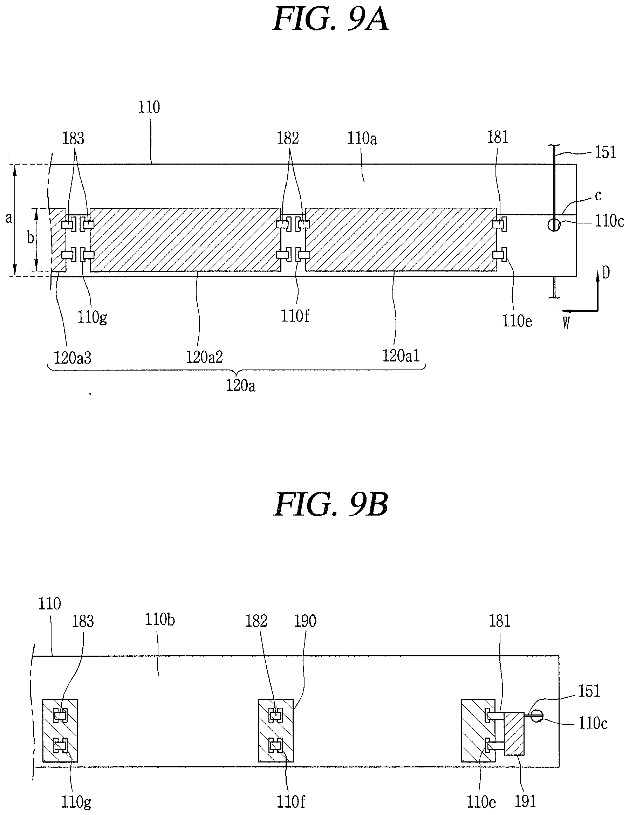

The arrangement of the solar cell modules will be described with reference to FIG. 9a.

FIG. 9a is a plan view showing one side of the slat 110.

One side of the slat 110 shown in FIG. 9a refers to the convex curved surface 110a of the slat 110. A plurality of solar cell modules 120a are attached to the convex curved surface 110a of the slat 110, and each solar cell module 120a consists of a set of sub-modules 120a1, 120a2 and 120a3.

In FIG. 9a, the transverse direction of the slat 110 is represented by W, and the longitudinal direction of the slat 110 is represented by D. The length of the curved surface of the slat 110 in the longitudinal direction is represented by a, the length of the curved surface of the solar cell module 120a in the longitudinal direction is represented by b, and the transverse centerline of the slat 110 is represented by c.

The convex curved surface 110a of the slat 110 can be divided into one side and the other side with respect to the transverse centerline c. One side of the transverse centerline c in Fig. 9a means the region below the transverse centerline c, and the other side means the region above the transverse centerline c. Similarly, one side of the transverse centerline c indicates the regions S1 to S5 in Fig. 7, and the other side of the transverse centerline c indicates the regions S6 to S10 in FIG. 7.

When the convex curved surface 110a is divided into the first curved surface and the second curved surface, one side of the transverse centerline c corresponds to the first curved surface S1 to S5, and the other side corresponds to the second curved surface S6 to S10. When the sunlight is projected in an inclined direction, the shadow S is created on the second curved surface S6 to S10 by the slat (not shown) just above. On the contrary, the first curved surface may or may not have the shadow S depending on the altitude of the sun. Referring to Table 1, since power generation efficiency of the solar cells in the region S1 has a value greater than 0 regardless of the season, a region in which the shadow S is not created always exists on the first curved surface. On the contrary, since power generation efficiency of the solar cells in the region S10 is 0 regardless of the season, a region in which the shadow S is created always exists on the second curved surface.

Referring to FIG. 9a, the solar cell module 120a is eccentrically disposed on one side with respect to the transverse centerline c of the slat 110. Here, Being eccentrically disposed means that the longitudinal center of the solar cell module 120a is not on the transverse centerline c of the slat 110 but on the first curved surface. It can be seen that the solar cell module 120a is disposed below the curved surface 110a in FIG. 9a. Accordingly, the solar cell module 120a is disposed so that the area covering the first curved surface is larger than the area covering the second curved surface.

The reason why the solar cell module 120a is disposed eccentrically toward the first curved surface is that the shadow S is created on the second curved surface. In order to maximize power generation efficiency of the solar cell module 120a, the solar cell module 120a should be disposed at a position having the maximum solar radiation, and the first curved surface has a greater solar radiation than the second curved surface.

It is most preferable that the lower end of the solar cell module 120a is disposed to contact the lower end of the slat 110. It is because, referring to FIG. 7, the solar cells have the highest power generation efficiency in the region S1. The lower end of the solar cell module 120a and the lower end of the slat 110 indicate the lowermost portions in FIG. 9a.

However, the lower end of the solar cell module 120a may not be necessarily brought into contact with the lower end of the slat 110, so the lower end of the solar cell module 120a may be spaced apart from the lower end of the slat 110 by a predetermined distance. In this case, the predetermined distance is preferably equal to or less than 1/10 of the length a of the curved surface of the slat 110 in the longitudinal direction. It is because, as shown in Table 1, power generation efficiency in the region S1 has the highest value.

According to the above description, the length b of the curved surface of the solar cell module 120a in the longitudinal direction should be 50 to 70%, and more preferably 63 to 70%, of the length a of the curved surface of the slat 110 in the longitudinal direction. When the length b of the curved surface of the solar cell module 120a in the longitudinal direction is 50% of the length a of the curved surface of the slat 110 in the longitudinal direction, if the lower end of the solar cell module 120a is brought into contact with the lower end of the slat 110, the upper end of the solar cell module 120a is brought into contact with the transverse centerline c of the slat 110.

Moreover, when the length b of the curved surface of the solar cell module 120a in the longitudinal direction exceeds 50% of the length a of the curved surface of the slat 110 in the longitudinal direction or when the lower end of the solar cell module 120a is spaced apart from the lower end of the slat 110, the upper end of the solar cell module 120a is disposed on the second curved surface corresponding to the other side with respect to the transverse centerline c of the slat 110.

Meanwhile, when the solar cell module 120a has the maximum size defined by the present invention, the length b of the curved surface of the solar cell module 120a in the longitudinal direction is 70% of the length a of the curved surface of the slat 110 in the longitudinal direction. Here, when the lower end of the solar cell module 120a is disposed to contact the lower end of the slat 110, the solar cell module 120a is disposed to cover the regions S1 to S7 of the slat 110. Therefore, the total area of the solar cell module 120a can be divided into seven regions S1 to S7.

5/7 of the total area of the equally-divided solar cell module 120a is disposed to cover the first curved surface, and 2/7 thereof is disposed to cover the second curved surface. When the size of the solar cell module 120a is smaller than the maximum size, it is preferable that the area covering the first curved surface is maintained and only the area covering the second curved surface is reduced. Thus, the area covering the first curved surface will be larger than 5/7 (5/7 or more) and the area covering the second curved surface will be smaller than 2/7 (2/7 or less).

In order for the length b of the curved surface of the solar cell module 120a in the longitudinal direction to correspond to up to 70% of the length a of the curved surface of the slat 110 in the longitudinal direction, the solar cells should be flexible enough to be attached to the curved surface 110a of the slat 110. As described above, since the solar cells of the present invention include the thin film group III-V compound semiconductor which can be bent, they can be attached to the convex curved surface 110a of the slat 110.

In particular, when the convex curved surface 110a of the slat 110 has an uneven curvature, inflection points may be formed along the transverse centerline c. Also in this case, since the solar cells including the thin film group III-V compound semiconductor have flexibility, the solar cell module 120a can be disposed to cover the inflection points.

Finally, the electrical connection structure of the solar cell module 120a will be described below.

It is inevitable that the solar cell module 120a is disposed on the convex curved surface 110a of the slat 110 for the purpose of power generation. However, the ribbons 181 and 182 and the multi-contact connector 191 for electrical connection of the solar cell module 120a are disposed on the rear surface 110b of the convex curved surface 110a to maintain reliability of the electrical connection and improve the external appearance.

Holes 110e, 110f and 110g are formed in the slat 110 on one side and the other side of each sub-module 120a1, 120a2 and 120a3. Referring to FIG. 9a, two holes 110e, 110f and 110g are formed on one side and the other side of each sub-module 120a1, 120a2 and 120a3. Accordingly, a total of four holes 110e, 110f and 110g are formed between the two adjacent sub-modules 120a1, 120a2 and 120a3.

The solar cell module 120a includes the ribbons 181, 182 and 183 for connecting the sub-modules 120a1, 120a2 and 120a3 in series to each other. The ribbons 181, 182 and 183 are connected to the two sub-modules 120a1, 120a2 and 120a3 disposed adjacent to each other via the rear surface 110b of the convex curved surface 110a through the holes 110e, 110f and 110g of the slat 110, respectively. As the ribbons 181, 182 and 183 pass through the rear surface 110b of the slat 110, they can be least exposed to the convex curved surface 110a of the slat 110.

FIG. 9b is a bottom view showing the other side of the slat 110.

The ribbons 181, 182 and 183 passing through the holes 110e, 110f and 110g via the rear surface 110b are exposed through the rear surface 110b. The window blind includes insulating tapes 190 disposed to cover the holes and the ribbons 181, 182 and 183 exposed through the rear surface 110b. The insulating tapes 190 are attached to the rear surface 110b of the slat 110.

The insulating tapes 190 can prevent the ribbons 181, 182 and 183 from being damaged on the rear surface 110b of the slat 110 by the external environment. In addition, the insulating tapes 190 have electrical insulation, which prevents shorts from occurring due to the exposure of the ribbons 181, 182 and 183.

The multi-contact connector 191 is disposed on the rear surface 110b of the slat 110. The multi-contact connector 191 can be electrically connected to various ribbons. The ribbon 181 connected to the outermost sub-module 120a1 among the sub-modules 120a1, 120a2 and 120a3 is extended to the rear surface 110b of the slat 110 through the hole 110e of the slat 110 and connected to the multi-contact connector 191.

The window blind includes a cable 151 connected to the multi-contact connector 191. The cable 151 is electrically connected to the multi-contact connector (not shown) of the slat (not shown) just above and the multi-contact connector (not shown) of the slat (not shown) just below through the wiring hole 111c formed in the slat 110. As described above, the solar cell module groups can be connected in parallel to each other by the cable 151.

The window blind discussed earlier is not limited to the configurations and methods of the above embodiments, but various modifications can be made on these embodiments by selectively combining all or a part of each embodiment.

According to the present invention, the solar cell modules attached to the convex curved surfaces of the slats consist of the set of solar cells, and the carrier generating portions of the solar cells are made of the group III-V compound semiconductor, so the solar cells and the solar cell modules consisting of such solar cells have flexibility, lightweight characteristics, and high output performance.

According to these characteristics, the solar cell modules can be disposed to cover more than half of the convex curved surface of the slat. More preferably, the solar cell modules can be attached to cover 63 to 70% of the convex curved surface of the slat. Power generation efficiency of the solar cell modules attached to the convex curved surface of the slat is limited by the shadow caused by the slat just above, and the area ratio of the solar cell modules with saturated power generation efficiency is about 70% of the convex curved surface. Even if the solar cell modules occupy about 70% of the convex curved surface, since the solar cell modules have flexibility, they can be attached to the convex curved surface of the slat without any problem.

In addition, according to the present invention, since the connection structure between the solar cell modules and the connection structure between the solar cell module groups disposed on the different slats are mostly disposed on the rear surface of the slats, they can be less affected by the exposure of the slats to the external environment. Even if the window blind is installed outside the building, the connection structures can be protected from external impacts as well as weather influences such as high solar radiation and precipitation. As a result, the connection structures are not visible on the convex curved surfaces of the slats on which the solar cell modules of the slats are disposed, which is advantageous in terms of design.

The sub-modules are not necessarily connected by the ribbons. In another embodiment, for example, the respective sub-modules may partially overlap with each other to be directly electrically connected to each other.

Furthermore, according to the present invention, even if the window blind is installed outside the building, the solar cell modules and the connection structures can be protected by the encapsulation film and the rear encapsulation film.

## Claims

1. A window blind (100), comprising:
a slat (110) having a surface; and
a solar cell module (120) attached to the surface of the slat (110), the solar cell module (120) including a plurality of solar cells (SC),
wherein each of the solar cells (SC) includes a bendable thin film group III-V compound semiconductor,
a length of a surface of the solar cell module (120) in a longitudinal direction of the slat (110) is at least half a length of the surface of the slat (110) in the longitudinal direction, and
the solar cell module (120) is disposed offset to one side in a transverse direction relative to centerline (c) of the slat (110) oriented in the longitudinal direction.

2. The window blind (100) of claim 1, wherein the length of the surface of the solar cell module (120) in the longitudinal direction is less than or equal to 70% of the length of the surface of the slat (110) in the longitudinal direction.

3. The window blind (100) of claim 1 or 2, wherein the length of the surface of the solar cell module (120) in the longitudinal direction is 63% to 70% of the length of the surface of the slat (110) in the longitudinal direction.

4. The window blind (100) of any one preceding claim , wherein
a lower end of the solar cell module (120) is in contact with a lower end of the slat (110) or spaced apart from the lower end of the slat (110) by a predetermined distance,
an upper end of the solar cell module (120) is in contact with the centerline (c) of the slat (110) or disposed between the centerline (c) and an upper end of the slat (110), the upper end of the slat (110) being disposed opposite to and spaced apart from the lower end of the slat (110), and
the predetermined distance is less than or equal to 1/10 of the length of the surface of the slat (110) in the longitudinal direction

5. The window blind (100) of any one preceding claim, wherein
the surface comprises:
a first surface disposed on one side of the centerline (c); and
a second surface disposed on an opposite side of the centerline (c),
the solar cell module (120) is disposed so that an area of the solar cell module (120) covering the first surface is larger than an area of the solar cell module (120) covering the second surface,
the solar cell module (120) is disposed so that less than or equal to 2/7 of a total area of the solar cell module (120) covers the second surface, and
a remaining area of the solar cell module (120) covers the first surface.

6. The window blind (100) of any one preceding claim, wherein
the surface of the slat (110) is curved,
the surface of the slat (110) includes inflection points disposed along the centerline (c), and
the solar cell module (120) is disposed to cover the inflection points.

7. The window blind (100) of any one preceding claim, wherein
the solar cell module (120) includes:
a set of sub-modules (120a1, 120a2, 120a3) including the solar cells (SC), the sub-modules (120a1, 120a2, 120a3) being spaced apart from each other on the slat (110); and
ribbons (181, 182) configured to connect adjacent sub-modules (120a1, 120a2, 120a3),
the slat (110) includes holes (110e, 110f, 110g) disposed on either side of each sub-module (120a1, 120a2, 120a3), and
the ribbons (181, 182) are configured to pass through the holes (110e, 110f, 110g) such that a portion of the ribbons (181, 182) is disposed on a rear surface of the slat (110).

8. The window blind (100) of claim 7, wherein the window blind (100) further comprises insulating tapes (190) disposed on the holes (110e, 110f, 110g) and the portion of the ribbons (181, 182) disposed on the rear surface.

9. The window blind (100) of claim 7 or 8, wherein each sub-module (120a1, 120a2, 120a3) comprises an interconnector (IC) for connecting the solar cells (SC), the interconnector (IC) comprising:
a base (IC1);
a conductive layer (IC2) disposed on one surface of the base (IC1) and configured to electrically connect two adjacent solar cells (SC) ; and
an insulating layer (IC3) disposed on the conductive layer (IC2) and configured to prevent shorts in between the solar cells (SC).

10. The window blind (100) of claim 9, wherein the interconnector (IC) and the slat (110) include a coating configured to absorb at least 80% of visible light.

11. The window blind (100) of claim 9 or 10, wherein
the base (IC1) includes copper (Cu) having a thickness of 10 µm to 200 µm, and
the conductive layer (IC2) includes a tin-lead alloy (SnPb) having a thickness of 1 µm to 100 µm.

12. The window blind (100) of any one of claims 7 to 11, wherein
the slat (110) extends from a first end to a second end along the longitudinal direction, at least one submodule is disposed adjacent the first end or the second end;
a ribbon (181, 182) connected to the at least one sub-module (120a1, 120a2, 120a3) extends to the rear surface through a hole (110e, 110f, 110g) in the slat (110) and is connected to a multi-contact connector (191) disposed on the rear surface,
the window blind (100) further comprises:
a cable (151) connected to the multi-contact connector (191), the cable (151) further being connected to a multi-contact connector (191) of a slat (110) disposed above the slat (110); and
a support (160) surrounding the cable (151), the support (160) being configured to prevent folding or twisting of the cable (151), and
the support (160) is made of at least one of a metal, a synthetic resin, and a synthetic fiber.

13. The window blind (100) of any one preceding claim, further comprising:
an encapsulation film (171) including:
a first portion (171a) configured to cover the surface of the slat (110) and the solar cell module (120); and
two second portions (171b) extending from the first portion (171a), the two second portions (171b) being attached to the rear surface of the slat (110), and
a rear encapsulation film (172) configured to cover the two second portions (171b) and the rear surface.

14. The window blind (100) of any one preceding claim, wherein the window blind (100) is installed outside a building to be directly exposed to the sunlight.

15. The window blind (100) of any one preceding claim, wherein
the solar cell module (120) includes a plurality of sub-modules (120a1, 120a2, 120a3) having the solar cells (SC), the sub-modules (120a1, 120a2, 120a3) being connected in series to each other,
the solar cell module (120) is one of a plurality of solar cell modules (120) connected in series to each other to form a solar cell module group (121, 122),
at least one solar cell module group (121, 122) is disposed on each slat (110) and connected in parallel to each other.
